# EUROPÄISCHE PATENTANMELDUNG

(11) **EP 3 477 748 A1**
(43) Veröffentlichungstag der Anmeldung: **01.05.2019**
(21) Anmeldenummer: 18199023.5
(22) Anmeldetag: 08.10.2018
(51) Int. Cl.: H01M 4/36, C01B 33/00, H01M 4/38, H01M 4/485, H01M 4/62, H01M 10/0525

(54) **STEIGERUNG DER LEBENSDAUER VON SILIZIUMBASIERTEN NEGATIVEN ELEKTRODEN DURCH PARTIKEL MIT SILIZIUMOXID- UND LIPON-BESCHICHTUNG**

(30) Priorität: 13.10.2017 DE 102017218388
(71) Anmelder: VOLKSWAGEN AKTIENGESELLSCHAFT, 38440 Wolfsburg (DE)
(72) Erfinder: Schramm, Linda-Susann, 38100 Braunschweig (DE)
(74) Vertreter: Schrell, Andreas

(57) **Zusammenfassung**

Die vorliegende Erfindung betrifft siliziumbasiertes Aktivmaterial für negative Elektroden, insbesondere Elektroden mit gesteigerter Lebensdauer, insbesondere für den Einsatz in Batterien, Verfahren zu deren Herstellung, sowie die dieses siliziumbasierte Aktivmaterial enthaltenden negativen Elektroden, Batterien und Vorrichtungen.

## Beschreibung

Die vorliegende Erfindung betrifft siliziumbasiertes Aktivmaterial für negative Elektroden, insbesondere Elektroden mit gesteigerter Lebensdauer, insbesondere für den Einsatz in Batterien, Verfahren zu deren Herstellung, sowie die dieses siliziumbasierte Aktivmaterial enthaltenden negativen Elektroden, Batterien und Vorrichtungen.

Lithium-Ionen-Batterien (LIB) gelten heute als Schlüsseltechnologie in der Elektromobilität. Sie müssen hinsichtlich ihrer Kosten, ihres Gewichts, der Energiedichte, ihrer Lebensdauer, ihrer Sicherheit und ihrer Ladungsdauer deutlich optimiert werden.

Durch den Einsatz innovativer Elektrodenmaterialien ist es möglich, die Energiedichte von Lithium-Ionen-Batterien zu steigern (135 Wh/kg (2013), 280 Wh/kg (2018)) und die Reichweite von Elektrofahrzeugen erheblich zu erhöhen (von 190 km auf 500 km). In dieser Hinsicht ist Silizium ein vielversprechendes Aktivmaterial. Es besitzt, im Vergleich zum kommerziell eingesetzten Graphit, eine zehnfach höhere Kapazität und ein ähnlich niedriges Lithiierungspotential (0,5 V vs. Lithium-Lithium⁺). Da Silizium das zweithäufigste Material in der Erdkruste und damit die Herstellung mit geringen Kosten verbunden ist, das Material ungefährlich im Umgang und nicht toxisch ist, ist es aus industrieller Sicht attraktiv.

Bekannt ist es, dass während der ersten Zyklisierungen einer Batterie eine Solid Elektrolyte Interface (SEI), also eine Grenzschicht zwischen negativer Elektrode und Elektrolyt, in Folge einer reduktiven Zersetzung verschiedener Elektrolytkomponenten, wie Lösungsmittel, Additive und Verunreinigungen gebildet wird, welche bei den erreichten Spannungen thermodynamisch und elektrochemisch nicht stabil ist.

Die Bildung der SEI ist existentiell für die Funktionalität und die Lebensdauer von Lithium-Ionen-Batterien, da sie im Idealfall über eine gute ionische Leitfähigkeit verfügt und zugleich elektrisch isolierend wirkt. Damit unterdrückt sie weitestgehend, durch ihre kinetisch limitierende Wirkung, weitere Zersetzungen des Elektrolyten und wirkt weiteren Kapazitätsverlusten entgegen. Darüber hinaus schützt die SEI die Struktur des Aktivmaterials vor Exfoliation und damit die Zelle vor beachtlichen Kapazitätsverlusten.

Allerdings kommt es während der Formierung, also der Bildung, der SEI stets auch zu einem irreversiblen Kapazitätsverlust, welcher der Formierung zuzuschreiben ist.

Im Fall von kommerziellen Graphit-Elektroden ist der irreversible Kapazitätsverlust in Folge der SEI-Formation mit circa 2 bis 5 % im Verhältnis zu dem siliziumbasierter negativer Elektroden mit 20 bis 80 % sehr gering.

Im Fall der für den irreversiblen Kapazitätsverlust besonders anfälligen siliziumbasierten negativen Elektroden muss zwischen zwei verschiedenen Arten von irreversiblen Kapazitätsverlusten unterschieden werden. Neben dem Kapazitätsverlust während der anfänglichen Formierung, also einem initialen Kapazitätsverlust, kommt es zusätzlich zu einem Kapazitätsverlust in Folge des Atmens während der Zyklisierung.

Eine fundamentale Herausforderung, die der kommerziellen Anwendung von siliziumbasierten negativen Elektroden im Wege steht, ist daher die enorme Volumenänderung, das heißt das Atmen, des Materials beim Lithiierungs- und Delithiierungsprozess (Si₄Li₁₅: 280 % - 300 % vgl. LiC₆: 10 - 11 %). Das Atmen der siliziumbasierten negativen Elektrode hat die Pulverisierung der Partikel und damit weitere Probleme zur Folge. Insbesondere hat es verheerende Auswirkungen auf den Erhalt der Elektrodenarchitektur, was besonders bei hohen Flächenbeladungen zum Tragen kommt. Dies bewirkt Kontaktverluste innerhalb der Elektrode sowie zwischen Elektrode und Stromkollektor und spiegelt sich in einer Verschlechterung der elektrischen Leitfähigkeit wider. Weiterhin resultiert es in einem ständigen Aufreißen und Wachsen der SEI. Dies hat wiederum einen kontinuierlichen Li-Ionen-Verbrauch, einen ansteigenden Innenwiderstand in der Zelle, damit eine geringere Coulombsche Effizienz (CE) und eine ungenügende Zyklenstabilität zur Folge.

Die SEI hat eine Schlüsselfunktion für die Funktionalität sowie für die Lebensdauer und Sicherheit der Lithium-Ionen-Batterie. Eine *in situ* generierte SEI hat verschiedene Nachteile, darunter eine geringe elektrische Isolation, schlechte ionische Leitfähigkeit, mangelnde Adhäsion der SEI an die Elektrode, inhomogene Verteilung der SEI und/oder einzelner Komponenten der SEI auf der Elektrodenoberfläche und/oder elektrochemische Instabilität.

US 9,570,748 B2 offenbart eine Beschichtung von Kathoden aus LiPON oder Varianten davon zum Schutz der Kathode. Ebenso ist eine Methode zur Herstellung einer positiven Elektrode mit LiPON-Beschichtung und einer Batterie mit LiPON-Beschichtung offenbart.

US 2016/0351973 A1 offenbart eine Beschichtung von Kathoden- und Anodenaktivmaterial, und Festkörperelektrolyten zur Reduktion der Korrosion und Verbesserung der Lebensdauer einer Batterie. Weiterhin sind auch Verfahren zur Beschichtung offenbart.

Der vorliegenden Erfindung liegt das technische Problem zugrunde, Aktivmaterial für Elektroden und Batterien bereitzustellen, die die vorgenannten Nachteile nicht aufweisen, insbesondere eine gute elektrische Isolation, gute ionische Leitfähigkeit, gute Adhäsion der SEI an der Elektrode, homogene Verteilung der SEI und/oder einzelner Komponenten der SEI auf der Elektrodenoberfläche und/oder elektrochemische Stabilität aufweisen.

Die vorliegende Erfindung löst das ihr zugrundeliegende technische Problem durch die Bereitstellung der Lehren der unabhängigen Ansprüche.

Die vorliegende Erfindung löst das ihr zugrunde liegende technische Problem demgemäß also insbesondere durch die Bereitstellung eines siliziumbasierten Aktivmaterials für eine negative Elektrode, wobei das Aktivmaterial Silizium-Partikeln mit einem Durchmesser von 10 bis 75 nm aufweist, insbesondere in Form solcher Silizium-Partikel vorliegt, wobei die Silizium-Partikel einen, mit mindestens einer ersten und mindestens einer zweiten Beschichtung versehenen Kern aus Silizium aufweisen und wobei die erste Beschichtung eine Siliziumoxid-Beschichtung und die zweite Beschichtung eine LiPON-Beschichtung ist.

Die Erfindung sieht demgemäß ein Aktivmaterial vor, welches Silizium-Partikel mit einem Kern mit mindestens einer ersten und mindestens einer zweiten Beschichtung aufweist, wobei der Kern aus Silizium aufgebaut ist, insbesondere aus diesem besteht, und wobei der Kern teilweise oder vollständig, insbesondere vollständig, von der ersten Beschichtung umhüllt ist und wobei auf dieser ersten Beschichtung die zweite Beschichtung vorliegt, insbesondere diese erste Beschichtung teilweise oder vollständig, insbesondere vollständig, umhüllt. Die im erfindungsgemäßen Aktivmaterial vorhandenen Silizium-Partikel sind daher zumindest zweifach beschichtet.

Das Aktivmaterial der vorliegenden Erfindung umfasst daher Silizium-Partikel mit einem Durchmesser von 10 bis 75 nm, wobei jeder dieser Silizium-Partikel einen, mit mindestens einer ersten und mindestens einer zweiten Beschichtung versehenen Kern aus Silizium aufweist, wobei die erste Beschichtung eine Siliziumoxid-Beschichtung und die zweite Beschichtung eine LiPON-Beschichtung ist.

Insbesondere sieht die vorliegende Erfindung in bevorzugter Ausführungsform ein siliziumbasiertes Aktivmaterial vor, welches aus den vorstehend definierten zweifach-beschichteten Silizium-Partikeln besteht, das heißt allein aus solchen Partikeln aufgebaut ist.

In einer weiteren bevorzugten Ausführungsform kann vorgesehen sein, dass das Aktivmaterial der vorliegenden Erfindung zusätzlich zu den zweifach-beschichteten Silizium-Partikeln weiteres Aktivmaterial, beispielsweise Graphit, aufweist. In einer besonders bevorzugten Ausführungsform der vorliegenden Erfindung umfasst das siliziumbasierte Aktivmaterial für eine negative Elektrode der vorliegenden Erfindung Silizium-Partikel mit einem Durchmesser von 10 bis 75 nm, wobei jeder dieser Silizium-Partikel einen mit mindestens einer ersten und mindestens einer zweiten Beschichtung versehenen Kern aus Silizium aufweist und wobei die erste Beschichtung eine Siliziumoxid-Beschichtung und die zweite Beschichtung eine LiPON-Beschichtung ist, in einer Menge von mindestens 5, mindestens 10, mindestens 20, mindestens 30, mindestens 40, mindestens 50, mindestens 60, mindestens 70, mindestens 80, mindestens 90, mindestens 95, mindestens 96, mindestens 97, mindestens 98, und insbesondere mindestens 99 Gew.- % bezogen auf das siliziumbasierte Aktivmaterial.

In einer weiteren Ausführungsform können die auf 100 Gew.- % des vorliegend definierten Aktivmaterials aufaddierenden Gewichtsbestandteile durch ein anderes Aktivmaterial, insbesondere Graphit, gebildet sein.

In bevorzugter Ausführungsform ist das siliziumbasierte Aktivmaterial ein Aktivmaterial, das mindestens 5 Gew.-%, bevorzugt mindestens 10 Gew.-%, bevorzugt mindestens 20 Gew.-%, bevorzugt mindestens 30 Gew.-%, bevorzugt mindestens 40 Gew.-%, bevorzugt mindestens 50 Gew.-%, bevorzugt mindestens 60 Gew.-%, bevorzugt mindestens 70 Gew.-%, bevorzugt mindestens 80 Gew.-%, bevorzugt 100 Gew.-% Silizium aufweist, jeweils bezogen auf das Gesamtgewicht des Aktivmaterials.

In besonders bevorzugter Ausführungsform umfasst das siliziumbasierte Aktivmaterial Silizium und Graphit. In bevorzugter Ausführungsform ist das siliziumbasierte Aktivmaterial daher ein Aktivmaterial, das zusätzlich zu Silizium Graphit als Aktivmaterial aufweist und wobei das Graphit in einer Menge von mindestens 5 Gew.-%, bevorzugt mindestens 10 Gew.-%, bevorzugt mindestens 20 Gew.-%, bevorzugt mindestens 30 Gew.-%, bevorzugt mindestens 40 Gew.-%, bevorzugt mindestens 50 Gew.-%, bevorzugt mindestens 60 Gew.-%, bevorzugt mindestens 70 Gew.-%, bevorzugt mindestens 80 Gew.-% Graphit vorliegt, jeweils bezogen auf das Gesamtgewicht des Aktivmaterials.

In besonders bevorzugter Ausführungsform addiert die in den siliziumbasierten Aktivmaterial vorhandene Menge an Silizium zusammen mit Graphit auf 100 Gew.- %, bezogen auf das Gesamtgewicht des Aktivmaterials, auf.

Ein Aktivmaterial der vorliegenden Erfindung kann in vorteilhafter und überraschender Weise zum Aufbau einer besonders langlebigen Elektrode verwendet werden. Die in dem erfindungsgemäßen Aktivmaterial vorhandenen mindestens zwei unterschiedlichen Beschichtungen optimieren vorteilhafterweise die sich zwischen Elektrolyt und Elektrode ausbildende Grenzschicht. Sie erhöhen dadurch insbesondere die Lebensdauer Siliziumhaltiger Elektroden. Die erfindungsgemäßen Beschichtungen stellen daher gleichsam eine künstliche SEI dar und weisen den Vorteil auf, besonders dünn und flexibel zu sein. Sie sind mit einer ionischen Leitfähigkeit ausgestattet und elektrisch isolierend, und zwar besser als bei üblichen SEI-Komponenten. Sie weisen eine gute Adhäsion an den Kern auf, sind elektrochemisch stabil, sind homogen über den Kern verteilt und chemisch inert gegenüber dem Elektrolyten.

In einer bevorzugten Ausführungsform der vorliegenden Erfindung weisen die zweifach-beschichteten Silizium-Partikel einen Durchmesser von 10 bis 70 nm, insbesondere von 10 bis 60 nm, insbesondere von 10 bis 55 nm, insbesondere von 10 bis 50 nm, insbesondere von 10 bis 45 nm, insbesondere von 10 bis 40 nm, insbesondere von 10 bis 35 nm, insbesondere von 20 bis 75 nm, insbesondere von 20 bis 70 nm, insbesondere von 20 bis 60 nm, insbesondere von 20 bis 55 nm, insbesondere von 20 bis 50 nm, insbesondere von 20 bis 45 nm, insbesondere von 20 bis 40 nm, insbesondere von 20 bis 35 nm, insbesondere 30 bis 75 nm, insbesondere von 30 bis 70 nm, insbesondere von 30 bis 60 nm, insbesondere von 30 bis 55 nm, insbesondere von 30 bis 50 nm, insbesondere von 30 bis 45 nm, insbesondere von 30 bis 40 nm, insbesondere von 35 bis 75 nm, insbesondere von 35 bis 70 nm, insbesondere von 35 bis 60 nm, insbesondere von 35 bis 55 nm, insbesondere von 35 bis 50 nm, insbesondere von 35 bis 45 nm, insbesondere von 35 bis 40 nm, insbesondere von 40 bis 75 nm, insbesondere von 40 bis 70 nm, insbesondere von 40 bis 60 nm, insbesondere von 40 bis 55 nm, insbesondere von 40 bis 50 nm auf.

In einer bevorzugten Ausführungsform der vorliegenden Erfindung weist die LiPON-Beschichtung der Partikel eine Dicke von 0,2 bis 5 nm, insbesondere von 0,5 bis 5 nm, insbesondere von 1 bis 5 nm, insbesondere von 3 bis 5 nm, insbesondere von 0,2 bis 4 nm, insbesondere von 0,5 bis 4 nm, insbesondere von 1 bis 4 nm, insbesondere von 2 bis 4 nm, insbesondere von 0,2 bis 2 nm, insbesondere von 0,5 bis 2 nm, insbesondere von 1 bis 2 nm, insbesondere von 0,2 bis 1 nm, insbesondere von 0,5 bis 1 nm auf.

In einer bevorzugten Ausführungsform der vorliegenden Erfindung weist die Siliziumoxid-Beschichtung der Partikel eine Dicke von 0,5 bis 3 nm, insbesondere von 0,5 bis 2 nm, insbesondere von 0,5 bis 1 nm, insbesondere von 1 bis 3 nm, insbesondere von 1 bis 2 nm, insbesondere von 2 bis 3 nm.

In einer besonders bevorzugter Ausführungsform ist der Durchmesser der zweifach-beschichteten Silizium-Partikel die Summe aus dem Durchmesser des Kerns der Partikel und der Schichtdicke der ersten und der zweiten Beschichtung.

In einer besonders bevorzugten Ausführungsform wird die Größe der Partikel mittels Transmissionselektronenmikroskopie (TEM) bestimmt.

In einer besonders bevorzugten Ausführungsform der vorliegenden Erfindung besteht die Siliziumoxid-Beschichtung aus Siliziumdioxid und Siliziummonoxid, insbesondere aus Siliziummonoxid.

In einer besonders bevorzugten Ausführungsform der vorliegenden Erfindung besteht die Siliziumoxid-Beschichtung aus Siliziumdioxid.

Die vorliegende Erfindung betrifft unter anderem auch ein Verfahren zur Herstellung eines erfindungsgemäßen, siliziumbasierten Aktivmaterials für eine negative Elektrode, wobei das Verfahren folgende Verfahrensschritte umfasst:
a) Bereitstellen von Siliziumoxid-beschichteten Silizium-Partikeln mit einem Durchmesser von 9 bis 70 nm,
b) Beschichten der mit Siliziumoxid vorbeschichteten, in Verfahrensschritt a) bereitgestellten Silizium-Partikel mit LiPON mittels Atomic Layer Deposition-Verfahren (ALD) zum Erhalt mindestens einer zweiten Beschichtung und
c) Erhalt von Silizium-Partikeln mit einen Durchmesser von 10 bis 75 nm, mindestens einer Siliziumoxid-Beschichtung und mindestens einer LiPON-Beschichtung.

In einer besonders bevorzugten Ausführungsform der Erfindung werden in dem Verfahren zur Herstellung des siliziumbasierten Aktivmaterials Silizium-Partikel beschichtet mit Siliziummonoxid, Siliziumdioxid und/oder beidem bereitgestellt. In einer besonders bevorzugten Ausführungsform der vorliegenden Erfindung ist die mindestens eine erste Beschichtung aus 2, 3, oder mehr Beschichtungen aus Siliziumoxid aufgebaut, wobei diese mehreren ersten Beschichtungen alternierende Siliziummonoxid- und Siliziumdioxidbeschichtungen sein können.

In einer besonders bevorzugten Ausführungsform der vorliegenden Erfindung ist die mindestens eine erste Beschichtung aus einer, insbesondere einer einzigen, Siliziumoxid-Beschichtung aufgebaut

In einer besonders bevorzugten Ausführungsform der Erfindung werden in dem Verfahren zur Herstellung des siliziumbasierten Aktivmaterials Silizium-Partikel beschichtet mit Siliziummonoxid bereitgestellt.

In einer besonders bevorzugten Ausführungsform der Erfindung werden in dem Verfahren zur Herstellung des siliziumbasierten Aktivmaterials Silizium-Partikel beschichtet mit Siliziumdioxid bereitgestellt.

Ein weiterer Aspekt der vorliegenden Erfindung betrifft die Verwendung von erfindungsgemäßem siliziumbasierten Aktivmaterial als eine Komponente von Elektrodenmaterial, insbesondere von Elektroden.

Die vorliegende Erfindung betrifft auch ein siliziumbasiertes Elektrodenmaterial, welches das siliziumbasierte Aktivmaterial der vorliegenden Erfindung umfasst, gegebenenfalls zusammen mit einem Binder und gegebenenfalls weiteren Substanzen, zum Beispiel Leitadditiven.

Die vorliegende Erfindung betrifft unter anderem auch ein Verfahren zur Herstellung von siliziumbasierten negativen Elektroden, wobei das Verfahren folgende Verfahrensschritte umfasst:
d) Bereitstellen von erfindungsgemäßen Aktivmaterial,
e) Mischen des in Verfahrensschritt d) bereitgestellten Aktivmaterials mit Binder und gegebenenfalls weiteren Komponenten zum Erhalt eines Elektrodenmaterials,
f) Beschichten mindestens eines elektronenleitenden Elektrodenträgers mit dem in Verfahrensschritt e) erhaltenen Elektrodenmaterial und
g) Erhalt der siliziumbasierten negativen Elektrode.

Die vorliegende Erfindung betrifft auch siliziumbasierte negative Elektroden. In besonders bevorzugter Ausführungsform sind diese herstellbar, insbesondere hergestellt, nach einem der erfindungsgemäßen Verfahren.

In einer besonders bevorzugten Ausführungsform umfasst die siliziumbasierte negative Elektrode erfindungsgemäßes Aktivmaterial und einen Binder sowie gegebenenfalls weitere Substanzen, zum Beispiel Leitadditive, bevorzugt besteht aus diesen.

In einer bevorzugten Ausführungsform ist die siliziumbasierte negative Elektrode eine siliziumbasierte negative Kompositelektrode.

In bevorzugter Ausführungsform ist die siliziumbasierte negative Elektrode eine Elektrode, die mindestens 5 Gew.-%, bevorzugt mindestens 10 Gew.-%, bevorzugt mindestens 20 Gew.-%, bevorzugt mindestens 30 Gew.-%, bevorzugt mindestens 40 Gew.-%, bevorzugt mindestens 50 Gew.-%, bevorzugt mindestens 60 Gew.-%, bevorzugt mindestens 70 Gew.-%, bevorzugt mindestens 80 Gew.-%, Silizium aufweist, jeweils bezogen auf das Gesamtgewicht des Elektrodenmaterials.

In bevorzugter Ausführungsform ist die siliziumbasierte negative Elektrode eine Elektrode, die zusätzlich zu Silizium Graphit als Aktivmaterial aufweist und wobei das Graphit in einer Menge von mindestens 5 Gew.-%, bevorzugt mindestens 10 Gew.-%, bevorzugt mindestens 20 Gew.-%, bevorzugt mindestens 30 Gew.-%, bevorzugt mindestens 40 Gew.-%, bevorzugt mindestens 50 Gew.-%, bevorzugt mindestens 60 Gew.-%, bevorzugt mindestens 70 Gew.-%, bevorzugt mindestens 80 Gew.-% Graphit vorliegt, jeweils bezogen auf das Gesamtgewicht des Elektrodenmaterials.

In besonders bevorzugter Ausführungsform addiert die in der siliziumbasierten negativen Elektrode vorhandene Menge an Silizium zusammen mit Graphit auf 100 Gew.- %, bezogen auf das Gesamtgewicht des Elektrodenmaterials, des in der Elektrode vorhandenen Aktivmaterials auf.

In einer besonders bevorzugten Ausführungsform umfasst das Elektrodenmaterial der siliziumbasierten negativen Elektrode neben dem Aktivmaterial Binder, vorzugsweise in einer Menge von mindestens 1 Gew.-%, vorzugsweise mindestens 2 Gew.-%, vorzugsweise mindestens 3 Gew.-%, vorzugsweise mindestens 4 Gew.-%, vorzugsweise mindestens 5 Gew.-%, vorzugsweise mindestens 6 Gew.-%, vorzugsweise mindestens 7 Gew.-%, vorzugsweise mindestens 8 Gew.-%, vorzugsweise mindestens 9 Gew.-%, vorzugsweise mindestens 10 Gew.-%, vorzugsweise mindestens 12 Gew.-%, vorzugsweise mindestens 15 Gew.-%, vorzugsweise mindestens 20 Gew.-%, jeweils bezogen auf das Gesamtgewicht des Elektrodenmaterials.

Insbesondere betrifft die vorliegende Erfindung auch eine Halbzelle, Vollzelle und mindestens eine Zelle aufweisende Batterie, insbesondere Lithium-Ionen-Batterie, enthaltend mindestens eine erfindungsgemäße Elektrode, insbesondere eine Elektrode, umfassend die erfindungsgemäße siliziumbasierte negative Elektrode.

In besonders bevorzugter Ausführungsform betrifft die vorliegende Erfindung auch Halbzellen, Vollzellen oder Batterien, wobei die erfindungsgemäße mindestens eine siliziumbasierte negative Elektrode in den Halbzellen oder Vollzellen, insbesondere Zellen, zusammen mit weiteren Zellkomponenten in an sich üblicherweise verbaut werden.

In besonders bevorzugter Ausführungsform umfassen die Batterien Pouch-Zellen, Knopfzellen oder prismatische Zellen.

In besonders bevorzugter Ausführungsform betrifft die vorliegende Erfindung auch Vorrichtungen, enthaltend mindestens eine erfindungsgemäße Elektrode, insbesondere mindestens eine erfindungsgemäße Batterie, insbesondere Roboter oder Elektrofahrzeuge, beispielsweise elektrisch angetriebene Autos, Hybridfahrzeuge oder E-Bikes, oder Elektroflugzeuge, beispielsweise Drohnen oder Satelliten, elektrisch betriebene Wasserfahrzeuge, wie Sportboote, Unterwasserfahrzeuge oder Modellbauschiffe, oder portable Geräte, wie Lampen oder Kommunikations- und/oder Unterhaltungsgeräte, zum Beispiel Telefone, Smartphones, Laptops, Notebooks sowie Tablets.

Unter dem Begriff "Lithium-Ionen-Batterie" wird erfindungsgemäß sowohl eine primäre als auch sekundäre Lithium-Ionen-Batterie, bevorzugt eine sekundäre Lithium-Ionen-Batterie, verstanden. Eine primäre Lithium-Ionen-Batterie ist eine nicht-wiederaufladbare Lithium-Ionen-Batterie, eine sekundäre Lithium-Ionen-Batterie ist eine wiederaufladbare Lithium-Ionen-Batterie.

Unter dem Begriff "C-Rate" wird erfindungsgemäß der relative Lade- oder Entladestrom, bezogen auf die theoretische, spezifische Kapazität der mindestens einen siliziumbasierten negativen Elektrode, verstanden. Ein Ladestrom von C/5 bedeutet beispielsweise, dass eine galvanische Zelle mit einer Kapazität von 1 Ah mit 1/5 geladen wird.

Im Zusammenhang mit der vorliegenden Erfindung wird unter einer "positiven Elektrode" die Elektrode verstanden, die beim Entladen als Kathode (Elektronenakzeptor) und beim Laden als Anode (Elektronendonor) fungiert und unter der "negativen Elektrode" wird die Elektrode verstanden, die beim Entladen als Anode und beim Laden als Kathode fungiert.

Im Zusammenhang mit der vorliegenden Erfindung wird unter einer "siliziumbasierten negativen Elektrode" eine als Elektrode geeignete Struktur, umfassend ein auf einem elektronenleitenden Elektrodenträger angeordnetes Elektrodenmaterial, insbesondere Aktivmaterial, verstanden, welches Silizium umfasst oder aus diesem besteht.

Im Zusammenhang mit der vorliegenden Erfindung wird unter dem "Elektrodenmaterial" das Material verstanden, das den elektronenleitenden Elektrodenträger einer Elektrode beschichtet und insbesondere aus Aktivmaterial, Binder sowie gegebenenfalls weiteren Substanzen, zum Beispiel Leitadditive, zusammengesetzt sein kann.

Im Zusammenhang mit der vorliegenden Erfindung wird unter dem Begriff "Binder" ein einzelner Binder oder eine Mischung verschiedener Binder als Binderkomponenten verstanden, insbesondere weist der Binder verschiedene Binderkomponenten und gegebenenfalls weitere Additive auf.

Im Zusammenhang mit der vorliegenden Erfindung wird unter einem "Aktivmaterial" einer Elektrode das Material verstanden, das der Aufnahme oder Abgabe von Lithium-Ionen dient, insbesondere ein Lithium-Metallmischoxid oder Lithiumeisenphosphat im Fall einer positiven Elektrode oder insbesondere Silizium, Graphit, oder beides im Falle einer negativen Elektrode.

Im Zusammenhang mit der vorliegenden Erfindung wird unter dem Begriff "erste Beschichtung" eine Beschichtung verstanden, die direkt auf dem Kern der Partikel, das heißt dem unbeschichteten Silizium-Partikel, aufliegt, insbesondere diesen teilweise oder vollständig, insbesondere vollständig, umhüllt. In bevorzugter Ausführungsform der vorliegenden Erfindung können auch mehr als eine erste Beschichtung, insbesondere 2, 3, 4, 5 oder 6 sowie weitere erste Beschichtungen vorliegen, das heißt mehr als eine Siliziumoxidbeschichtung vorliegen, wobei sich die einzelnen Siliziumoxidbeschichtungen durch ein oder mehrere Parameter voneinander unterscheiden.

Im Zusammenhang mit der vorliegenden Erfindung wird unter dem Begriff "zweite Beschichtung" eine Beschichtung verstanden, die auf der ersten Beschichtung aufliegt, insbesondere diese teilweise oder vollständig, insbesondere vollständig, umhüllt. In einer besonders bevorzugten Ausführungsform der vorliegenden Erfindung kann auch mehr als eine zweite Beschichtung vorliegen, insbesondere 2, 3, 4, 5 oder 6 sowie weitere zweite Beschichtungen vorliegen, das heißt mehr als eine LiPON-Beschichtung vorliegen, wobei sich die einzelnen LiPON-Beschichtungen durch ein oder mehrere Parameter voneinander unterscheiden.

Im Zusammenhang mit der vorliegenden Erfindung wird unter einem Kern eines erfindungsgemäßen Silizium-Partikels der unbeschichtete Silizium-Partikel verstanden, der zusammen mit der mindestens einen ersten und der mindestens einen zweiten Beschichtung einen erfindungsgemäßen Silizium-Partikel des erfindungsgemäß bereitgestellten Aktivmaterials darstellt.

Im Zusammenhang mit der vorliegenden Erfindung wird unter "Atomic Layer Deposition" eine Methode zur Ablagerung dünner Beschichtungen an Oberflächen verstanden, wobei eine chemische Reaktion auf der zu beschichtenden Oberfläche stattfindet und eine dünne Lage von Atomen/Molekülen auf der Oberfläche abgeschieden wird. Hierzu werden in sequentieller Weise, durch Spülgänge mit einem inerten Gas getrennt voneinander, mindestens zwei Edukte einer chemischen Reaktion auf eine Oberfläche übertragen. Dieser Zyklus kann wiederholt werden, um eine Beschichtung aus mehreren Lagen und unterschiedlicher Dicke zu erhalten.

Weitere vorteilhafte Ausgestaltungen ergeben sich aus den Unteransprüchen.

Die Erfindung wird anhand der nachfolgenden Figuren und des Beispiels näher erläutert.

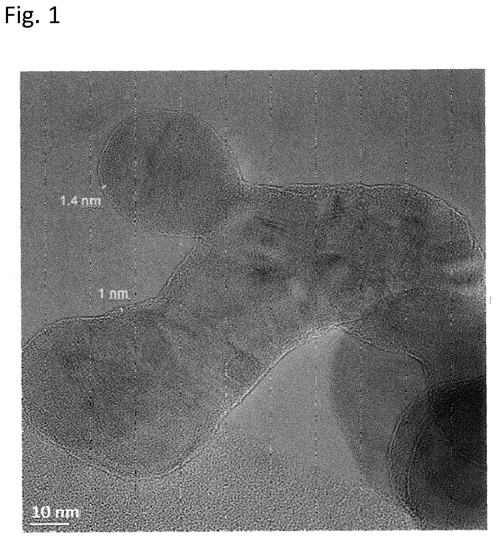

Die Figuren zeigen
- Figur 1: eine TEM-Aufnahme des Rohmaterials mit einer SiO₂-Schicht einer Stärke von ca. 1 nm,
- Figur 2: eine TEM-Aufnahme der mit LiPON beschichteten Partikel, und
- Figur 3: die relative Kapazität bezogen auf die erste C/3-Kapazität nach abgeschlossener Formierung einer Batterie mit einer negativen Elektrode mit 20 Gew.-% erfindungsgemäßen Siliziumpartikeln und einer Batterie mit negativer Elektrode mit 20 Gew.-% unbeschichteten Siliziumpartikeln (Standard-Knopfzelle).

### Beispiel

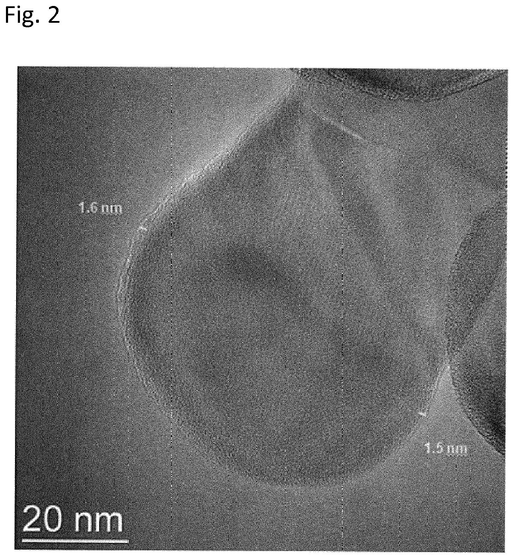

A) Silizium-Partikel mit einem Durchmesser von 30 bis 50 nm werden mit einer 1 nm dünnen Siliziumdioxid-Beschichtung bereitgestellt. Anschließend werden sie mittels Atomic Layer Deposition-Verfahren mit einer 0,5 nm dicken Schicht LiPON beschichtet. Das Ergebnis des Verfahrens, die beschichteten Siliziumpartikel, ist in Figur 2 abgebildet. Unter der Annahme, dass die bestehende SiO₂-Schicht circa 1 nm beträgt, ist die LiPON-Beschichtung von 0,5 nm bestätigt.
B) Die gemäß A) beschichteten Silizium-Partikel werden zur Elektrodenherstellung mit folgender Rezeptur verwendet:
   20 Gew.-% der zweifach-beschichteten Silizium-Partikel, erhalten gemäß A);
   60 Gew.-% Graphit (Imerys - C- NERGY™ SFG6)
   12 Gew.-% Imerys - C- NERGY™ SUPER C65
   8 Gew.-% Binder (Carboxymethyl Cellulose (700.000 g/mol): Poly(acrylic acid) (450.000 g/mol): Poly(acrylic acid-co-maleic acid) (350 g/mol), 1:1:1).

Zunächst werden diese Feststoffe mit Ausnahme des Binders im Dissolver mit Wolfram-Carbid-Kugeln (Elektrodenträger, 1 mm Durchmesser) vermengt und anschließend durch Zugabe des Binders in zwei Schritten verdünnt und die Viskosität eingestellt, wobei der pH-Wert der erhaltenen Paste 3 beträgt.

Die fertiggestellte negative Elektrode wurde in eine Knopfzelle mit Elektrolyt (LP 71 + 10 Gew.-% FEC) verbaut und mit einer Flächenbeladung von ca. 4,0 mAh/cm² (entspricht C/3) vermessen. Das Spannungsfenster betrug dabei 25 mV bis 0,9 V.

Während der Lithiierung wurde eine "Constant Current, Constant Volt" (CCCV)-Messung mit folgenden C-Raten verwendet:
Während CC: C/3 und während CV: C/20. Wohingegen beim Delithiieren eine CC-Messung mit C-Rate von C/3 verwendet wurde.

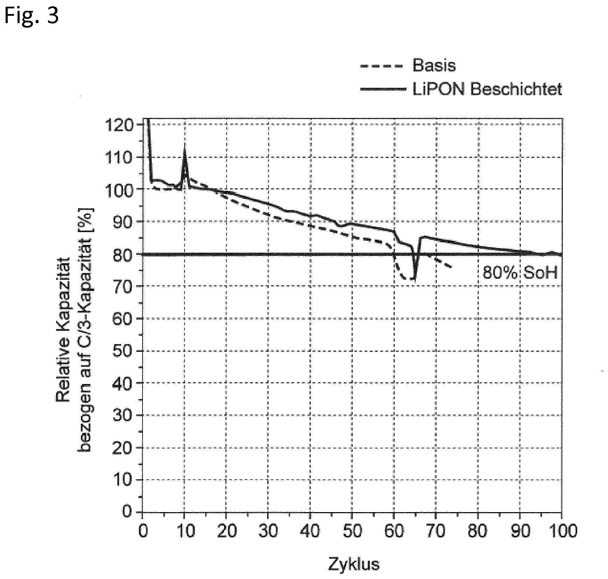

Anhand von Figur 3 lässt sich erkennen, dass die Knopfzelle mit erfindungsgemäßer negativer Elektrode über mehr Zyklen eine relative Kapazität mit mehr als 80 % ihrer Ausgangs-Kapazität aufweist, als eine Standard-Knopfzelle (anstatt erfindungsgemäßer Siliziumpartikel wurden unbeschichtete Siliziumpartikel zur Herstellung der negativen Elektrode der Knopfzelle verwendet). Während die Knopfzelle mit der erfindungsgemäßen negativen Elektrode erst ab circa 95 Zyklen eine relative Kapazität von unter 80 % aufweist, ist die relative Kapazität der Standard-Knopfzelle schon ab 60 bis 70 Zyklen auf unter 80 % der Ausgangs-Kapazität gefallen.

## Patentansprüche

1. Siliziumbasiertes Aktivmaterial für eine negative Elektrode, wobei das Aktivmaterial Silizium-Partikel mit einem Durchmesser von 10 bis 75 nm aufweist und wobei die Silizium-Partikel einen, mit mindestens einer ersten und mindestens einer zweiten Beschichtung versehenen Kern aus Silizium aufweisen, wobei die erste Beschichtung eine Siliziumoxid-Beschichtung und die zweite Beschichtung eine LiPON-Beschichtung ist.

2. Das siliziumbasierte Aktivmaterial nach Anspruch 1, wobei die Silizium-Partikel einen Durchmesser von 30 bis 50 nm aufweisen.

3. Das siliziumbasierte Aktivmaterial nach Anspruch 1 oder 2, wobei die LiPON Beschichtung der Silizium-Partikel eine Schichtdicke von 0,2 bis 5 nm aufweist.

4. Das siliziumbasierte Aktivmaterial nach Anspruch 3, wobei die LiPON-Beschichtung der Silizium-Partikel eine Schichtdicke von 0,5 bis 1 nm aufweist.

5. Das siliziumbasierte Aktivmaterial nach einem der vorstehenden Ansprüche, wobei die Siliziumoxid-Beschichtung der Silizium-Partikel eine Schichtdicke von 0,5 bis 3 nm aufweist.

6. Das siliziumbasierte Aktivmaterial nach einem der vorstehenden Ansprüche, wobei das Siliziumoxid Siliziummonoxid oder Siliziumdioxid ist.

7. Ein Verfahren zur Herstellung eines siliziumbasierten Aktivmaterials für eine negative Elektrode, insbesondere gemäß einem der Ansprüche 1 bis 6, wobei das Verfahren folgende Verfahrensschritte umfasst:
a) Bereitstellen von Siliziumoxid-beschichteten Silizium-Partikeln mit einem Durchmesser von 9 bis 70 nm,
b) Beschichten der mit Siliziumoxid vorbeschichteten, in Verfahrensschritt a) bereitgestellten Silizium-Partikel mit LiPON mittels Atomic Layer Deposition-Verfahren (ALD) zum Erhalt mindestens einer zweiten Beschichtung und
c) Erhalt von Partikeln mit einen Durchmesser von 10 bis 75 nm, mindestens einer Siliziumoxid-Beschichtung und mindestens einer LiPON-Beschichtung.

8. Verfahren nach Anspruch 7, wobei das verwendete Siliziumoxid Siliziummonoxid oder Siliziumdioxid oder eine Kombination von beiden ist.

9. Verfahren nach Anspruch 7 oder 8, wobei die LiPON-Beschichtung 0,2 bis 5 nm dick ist.

10. Verfahren nach einem der Ansprüche 7 bis 9, wobei die Siliziumoxid-Beschichtung 0,5 bis 3 nm dick ist.

11. Ein siliziumbasiertes Elektrodenmaterial umfassend ein siliziumbasiertes Aktivmaterial nach einem der Ansprüche 1 bis 6 oder Erhalten nach einem Verfahren der Ansprüche 7 bis 10.

12. Verfahren zur Herstellung von siliziumbasierten negativen Elektroden, wobei das Verfahren folgende Verfahrensschritte umfasst:
d) Bereitstellen von Aktivmaterial gemäß einem der Ansprüche 1 bis 6 oder Erhalten aus einem Verfahren gemäß einem der Ansprüche 7 bis 10,
e) Mischen des in Verfahrensschritt d) bereitgestellten Aktivmaterials mit Binder und gegebenenfalls weiteren Komponenten zum Erhalt eines Elektrodenmaterials,
f) Beschichten mindestens eines elektronenleitenden Elektrodenträgers mit dem in Verfahrensschritt e) erhaltenen Elektrodenmaterial und
g) Erhalt der siliziumbasierten negativen Elektrode.

13. Eine siliziumbasierte negative Elektrode umfassend ein Aktivmaterial nach einem der Ansprüche 1 bis 6, ein Elektrodenmaterial nach Anspruch 11 oder ein Aktivmaterial herstellbar nach einem der Ansprüche 7 bis 10.

14. Eine siliziumbasierte negative Elektrode herstellbar nach einem Verfahren nach Anspruch 12.

15. Lithium-Ionen-Batterie, umfassend mindestens eine siliziumbasierte negative Elektrode nach einem der Ansprüche 13 oder 14.

16. Vorrichtung, umfassend mindestens eine Lithium-Ionen-Batterie nach Anspruch 15.
